# EUROPÄISCHE PATENTSCHRIFT

(11) **EP 0 227 589 B1**
(45) Veröffentlichungstag und Bekanntmachung des Hinweises auf die Patenterteilung: **24.02.1993**
(21) Anmeldenummer: 86730211.9
(22) Anmeldetag: 17.12.1986
(51) Int. Cl.: E05B 49/00, G07C 9/00

(54) **Vorrichtung zur Initialisierung einer Schaltung nach dem Prinzip des Synchronschalters**
Control device according to the synchronization switch system
Dispositif de commande fonctionnant selon le principe d'un interrupteur de synchronisation

(30) Priorität: 18.12.1985 DE 3544689
(43) Veröffentlichungstag der Anmeldung: 01.07.1987
(73) Patentinhaber: Angewandte Digital Elektronik GmbH, 21521 Dassendorf (DE)
(72) Erfinder: Schweim, Ronald, D-2359 Schmalfeld (DE); Kreft, Hans-Diedrich, D-2055 Dassendorf (DE)

(56) Entgegenhaltungen:
- EP-A- 0 151 087
- WO-A-85/03831
- DE-A- 3 221 356
- DE-A- 3 242 551
- US-A- 4 546 241

## Beschreibung

Werden in der Automobilbranche Schlussel eingesetzt, welche nach dem Prinzip des Synchronschalters (Patent-Nr. DE-C-3 149 789 arbeiten, so tritt das Problem der andauernden Stromversorgung der Schloßspule auf. Bekanntlich wird nach diesem Prinzip eine im Schlüssel befindliche Spule zur Übertragung von elektrischer Energie vom Schloß als stationärem Teil zum Schlüssel als beweglichem Teil benutzt. Eine im Schlüssel befindliche Elektronik wird durch diese Energieübertragung aktiviert und dann die Schlüsselspule zu genau definierten Zählereignissen, welche durch die Anzahl von Halbwellen der Übertragung frequenzbestimmt sind, kurzschließen. Diese Kurzschlüsse können auf Seiten der Schloßspule nachgewiesen werden und dienen zur Übertragung von Codierungen, welche auf dem Schlüssel abgespeichert sind.

Bei dieser Lösung muß ein Autoschloß andauernd mit Leistung versorgt werden, womit eine Autobatterie vor allem bei geparktem Auto - also nicht laufendem Motor - übermäßig stark belastet würde.

Es wurde in der Praxis eine Lösung dieses Problems angestrebt, bei der die Schloßspule erst aktiviert wird, wenn ein Schlüssel in die Nähe des Schloßes gebracht wird. Die einfachste Lösung wäre durch Betätigung eines elektromechanischen Schalters gegeben, welcher zum Beispiel als Mikroschalter ausgeformt beim Einschieben des Schlüssels die Elektronik aktiviert und die Spule mit Oszillator an die Stromversorgung anschließt. Eine solche Lösung macht jedoch die Vorteile der berührungslosen Energie- und Signalübertragung nach dem Prinzip des Synchronschalters zunichte, da ein mechanischer Kontakt mit allen bekannten technischen Nachteilen wieder im Schloß enthalten ist. Auch optische Systeme (Fotoeffekt), magnetosensitive Schalter (z.B. Sensoren nach dem Halleffekt, Reed-Relais) sind jeweils nur mit zusätzlichem technischem Aufwand am Schloß oder am Schlüssel zu benutzen.

Nachteilig bei all diesen Systemen ist neben dem zusätzlichen Aufwand die ungehinderte Beeinflussung von außen. Ein Kontakt kann sehr einfach durch einen schlüsselähnlichen Gegenstand von außen am Schloß betätigt werden und die Batterie kann derart von Unbefugten leicht entladen werden.

Am günstigsten sollte eine technische Lösung sein, welche bereits vorliegende Eigenschaften einer Schaltung nach dem Prinzip des Synchronschalters benutzt. Es wurde nach einer technischen Lösung gesucht, welche mit geringst möglichem Energieaufwand (Leistungsverbrauch) andauernd aktiv ist und die räumliche Annäherung eines Schlüssels rechtzeitig erkennt, wodurch die Aktivierung einer Elektronik erreicht wird, welche Schloßspule und gekoppelte Schlüsselspule mit Leistung nach dem Prinzip des Synchronschalters versorgt.

Die zu suchende Lösung durfte keinesfalls das in der Praxis äußerst bewährte und tragende Prinzip des Synchronschalters nachteilig beeinflussen. Auch soll eine Drehbewegung des Schlussels im Schloß nicht nötig sein, um im Winter vereiste Schlösser allein durch Einstecken des Schlüssels betätigen zu können. Ferner sollten Bauteileeigenschaften (langfristiges Driften von Parametern) sowie Temperatureinflüsse und sonstige Umwelteinflüsse die Lösung nicht beeinflussen. Ein schlüsselähnlicher Gegenstand sollte andererseits keinesfalls die dauerhafte Aktivierung des Schloßes bewirken und damit wieder zu den oben geschilderten bekannten Problemen führen.

Neben den verschiedenen oben erwähnten Problemlösungen, welche alle einen irgendwie gearteten Schalter enthalten, fielen auch Lösungen nach dem Prinzip verstimmter Oszillatorschaltungen aus, da ein dauerhaft arbeitender Schwingkreis Leistung abstrahlt, womit die oben geschilderten Probleme wieder vorhanden sind; zum anderen sind Schwingkreise äußerst abhängig von den Parametereigenschaften ihrer Bauteile.

Die Erfindung geht aus von der EP 0151087 A2 aus der eine Vorrichtung zur gegenseitigen Informationsübertragung bekannt ist, bei der eine nach dem Prinzip des Synchronschalters aufgebaute Schaltung Verwendung findet, bei der kurze Spannungssignale einer ersten Spule als einem ersten Teil zugeführt werden und diese Spule zur Energieübertragung zu einer zweiten Spule auf einem bewegbaren Teil und auch zum Empfang von Kursschlüssen dient.

Die erfindungsgemäße Lösung ist im Kennzeichen des Anspruchs 1 angegeben.

Eine vorzugsweise Ausgestaltung ergibt sich aus dem Anspruch 2.

Nachfolgend wird die Erfindung anhand der Zeichnungen erläutert.

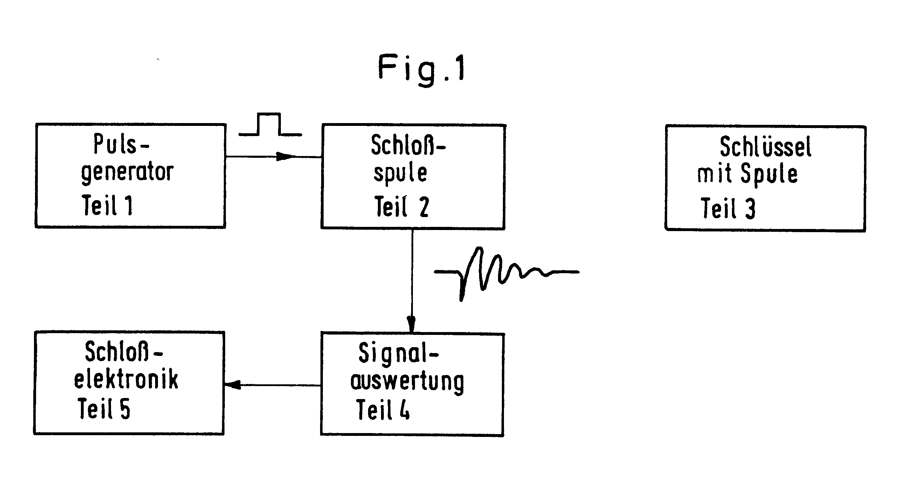

Bild 1 zeigt die prinzipielle Problemlosung. In einem Pulsgenerator (Teil 1) werden Impulse erzeugt, deren Pulsdauer sehr kurz im Verhältnis zur Zeit bis zum nächsten Puls ist. Diese Pulse kommen zur Schloßspule im Teil 2, welche mit Kondensatoren beschaltet wie ein Schwingkreis wirkt und den ankommenden Puls verformt. Die Pulsverformung (Pulsantwort des Teiles 2) wird einer Signalauswertung in Teil 4 zugeführt. Je nachdem ob ein Schlüssel mit Spule (Teil 3) Teil 2 zugeführt wurde, gibt die Signalauswertung (Teil 4) ein unterschiedliches Signal an die Schloßelektronik (Teil 5).

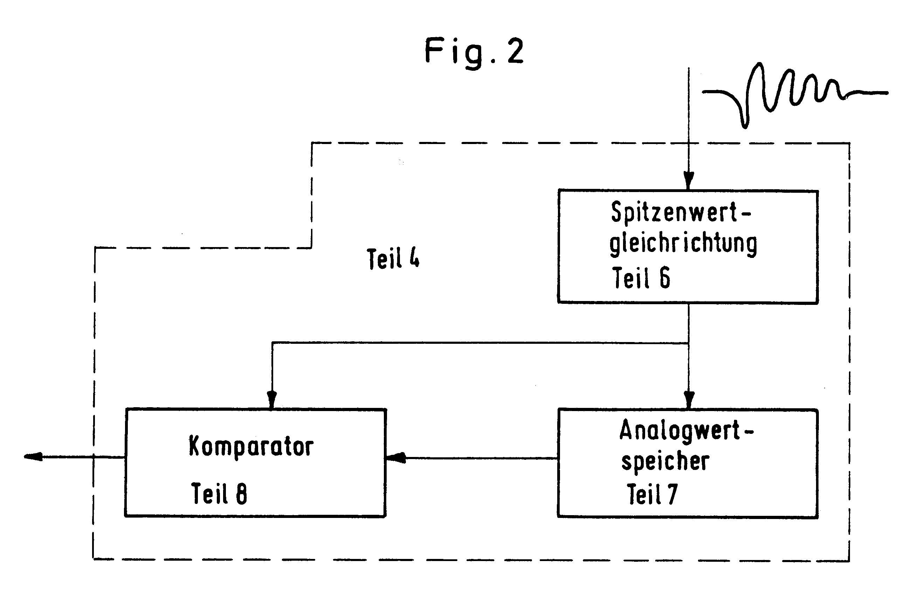

Bild 2 zeigt das Blockschaltbild von Teil 4.
Zunächst wird in Teil 6 die Pulsantwort des Teiles 2 einer Spitzenwertgleichrichtung zugeführt. Damit wird in Abhängigkeit von der Pulsantwort eine Gleichspannung von der Höhe erzeugt, wie sie durch die Dimensionierung des Spitzenwertgleichrichters vorgegeben ist. Diese Spannung gelangt einmal unmittelbar zum Komparator (Teil 8). Gleichzeitig wird die per Spitzenwertgleichrichtung gewonnene Gleichspannung genutzt, um im Analogwertspeicher (Teil 7) eine Spannung zu speichern. Ändert sich nun die Spannung am Spitzenwertgleichrichter schneller als die am Ausgang des Analogspannungsspeichers, so wird der nachgeschalteter Komparator (Teil 8) je nach Dimensionierung von Teil 6 und Teil 7 andere Eingangsverhältnisse vorfinden, sofern die Pulsantwort im Spitzenwertgleichrichter zur Änderung seiner Spannung führt. Durch die Änderung dieser Verhältnisse kann der Komparator zum Umschalten veranlaßt werden, wobei dieses Umschalten die Ursache hat, daß ein Schlüssel in Schloßnähe gebracht wurde und eine geänderte Pulsantwort an der Schloßspule erzeugt wurde.

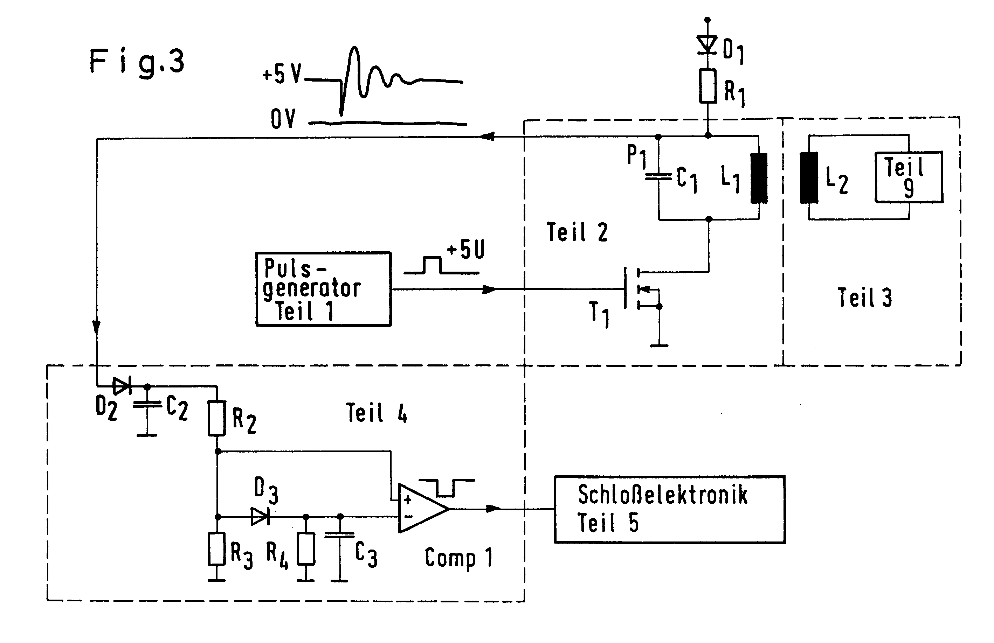

Eine detailierte Ausgestaltung der Schaltungsanordnung ist in Bild 3 gegeben.

Ein Pulsgenerator (Teil 1) erzeugt (z.B. als CMOS-Schaltkreis aufgebaut) Pulse mit geringem Taktverhaltnis, so daß ein geringer mittlerer Energieaufwand vorliegt. Diese Pulse gelangen über die Basis des Transistozs T1, welcher somit das System Kondensator C1 und Spule L1 mit einer Sprungfunktion belegt, da sich durch das Durchschalten von T1 über R1 und D1 ein Stromfluß ergibt. Dieses Signal am Punkt P1 als Systemantwort auf eine Eingangsänderung ist aber abhängig von der Induktivität L1 welche mit L2 bei räumlicher Nähe gekoppelt ist. Somit werden die Pulsantworten am Punkt P1 von der Anwesenheit einer zweiten Spule L2 abhängen, wie sie bei diesem System auf einem Schlüssel mit Schlüsselelektronik (Teil 9) als Träger in Teil 3 enthalten ist. Das Signal von Punkt P1 wird an die Diode D2 gegeben, welche als Spitzenwertgleichrichter wirkt und am Kondensator C2 für eine bestimmte Spannung sorgt. Gleichzeitig wird über den Widerstand R2 und über die Diode D3 ein weiterer Kondensator C3 mit einer Analogspannung geladen, deren Höhe von der Auslegung der Widerstände abhängt. Die Schaltung kann nun so dimensioniert sein, daß ohne magnetische Koppelung von L1 und L2 der Komparator COMP1 je nach Beschaltung Plus- oder Minusspannung am Ausgang liegen hat. Ändert sich nun das Spannungsverhältnis von C2 zu C3 kurzfristig, kann der Komparator COMP1 zum Umschalten gebracht werden. Wesentlich für das Schalten des Komparators COMP1 sind die unterschiedlichen Zeitkonstanten für die Entladung der Kondensatoren C2 bzw. C3. Während C2 sich über die Widerstände R2, R3/R4 entlädt, ist dies für C3 über den hochohmigeren Widerstand R4 möglich.
Somit ist die Entladungszeit für C3 größer als die für C2. Damit kann C3 als Analogspannungsspeicher angesehen werden und kurzfristige Änderungen, welche sich über die Spitzenwertgleichrichtung von D2 auf den Spannungswert von C2 auswirken, können den Komparator zum Umschalten bringen.

Wie ersichtlich, erfüllt diese Schaltung präzise die wesentlichen und eingangs dargestellten Anforderungen. Insbesondere wird jede langfristige Änderung von L1 (z.B. durch in der Nähe befindliche magnetische Materialien) immer zu demselben Zustand von COM1 führen, und nur kurzfristige Änderungen werden ein Signal erzeugen. Somit sind Materialänderungen der Bauteile bei Langfristigem Einsatz in einer Elektronik ebenso bedeutungslos wie unterschiedliche Temperatureinflüsse infolge ihrer langsamen Änderung keinen Einfluß haben.

Ein weiterer Gedanke besteht darin, im Teil 5 gleichzeitig die Signalauswertung der übertragenden Pulse nach dem Prinzip des Synchronschalters unterzubringen und derartige Schaltungen dann für längere Zeit zu deaktivieren, wenn COM1 seinen Ausgangszustand ändert, ohne daß über die Koppelung von L1 und L2 gleichzeitig Signale nach dem Prinzip des Synchronschalters gesendet werden

Nach dem hier beschriebenen Prinzip ist es möglich, Schaltungen zur Aktivierung eines Autoschloßes nach dem Prinzip des Synchronschalters zu bauen, die erst aktiviert werden und damit einen höheren Strom verbrauchen, wenn ein Schlüssel mit passender elektronischer Codierung sich im Schloß befindet.

## Patentansprüche

1. Vorrichtung zur Initialisierung einer nach dem Prinzip des Synchronschalters aufgebauten Schaltung, mit einer Schloßspule (L1) und einer Schlüsselspule (L2) in derartiger Ausgestaltung, daß der Schloßspule (L1) kurze Spannungssignale zugeführt werden und diese Schloßspule (L1) zur Energieübertragung zur Schlüsselspule (L2) und auch zum Empfang von Kurzschlüssen dient, welche auf die Schlüsselspule (L2) einwirken,
dadurch gekennzeichnet,
daß die Schloßspule (L1) mit einem Kondensator (C1) verbunden ist und zusammen mit diesem ein schwingendes System bildet, und daß dieses schwingende System die empfangenen Signale der Schloßspule (L1) gemäß der spezifischen Dimensionierung des schwingenden Systems weiterleitet an einen Spitzenwertdetektor, welcher in Abhängigkeit von der Form der zugeleiteten Signale eine Spannung erzeugt, daß zur Speicherung dieser Spannung ein zweiter Kondensator (C2) mit kurzer Speicherzeit vorgesehen ist, daß gleichzeitig diese Spannung über einem Spannungsteiler (R2, R3) an einen dritten Kondensator (C3) weiterleitbar ist, welcher gegenüber dem zweiten Kondensator (C2) eine längere Speicherzeit hat, daß ein Komparator vorgesehen ist, an dessen Eingängen die beiden Spannungen aus der zweiten Kondensator (C2) und aus dem dritten Kondensator (C3) anlegbar sind, der aufgrund des Unterschiedes der Spannungen des zweiten und dritten Kondengators (C2, C3) als Folge einer kurzfristgen Änderung der gekoppelten Induktivitäten der Schloßspule und der Schlüsselspule ein hiervon abhängendes Signal an seinem Ausgang erzeugt.

2. Vorrichtung nach Anspruch 1,
dadurch gekennzeichnet,
daß mit dem Augang dem Komparators eine Elektronik nach dem Prinzip des Synchronschalters verbunden ist, die in jedem Falle bei einer Änderung der Induktivität der gekoppelten Schloß- und Schlüsselspule (L1, L2) einschaltbar ist, derart, daß diese Elektronik untersucht, ob eine bestimmte Codierung nach dem Synchronschalterprinzip übertragen wird und daß ferner diese Elektronik die Schloßspule (L1) nur dann in einer vorgegebenen Zeit wieder aktiviert, wenn der empfangene Code in Übereinstimmung mit einem vorgegebenen Muster ist.

## Claims

1. Device for the initialization of a circuit which is designed according to the principles of a synchronous switch, with a lock coil (L1) and a key coil (L2) which are designed in such a manner that short voltage signals are sent to the lock coil (L1) and that this lock coil (L1) is used for the transmission of energy to the key coil (L2) and for the reception of short-circuits which act on the key coil (L2),
characterized by the fact
that the lock coil (L1) is connected to a capacitor (C1) with which it constitutes an oscillating system, and that this oscillating system, according to the specific dimensioning of the oscillating system, forwards the received signals of the lock coil (L1) to a peak-value detector which generates a voltage which depends on the shape of the signals forwarded; that a second capacitor (C2) with short storage time is provided for the storage of this voltage; that this voltage can at the same time be passed on via a voltage divider (R2, R3) to a third capacitor (C3) whose storage time is shorter than that of the second capacitor (C2); that a comparator exists to whose inputs the two voltages from the second capacitor (C2) and from the third capacitor (C3) can be applied, which comparator generates, due to the difference between the voltages of the second and third capacitor (C2, C3) as a consequence of a temporary change in the coupled inductances of the lock coil and of the key coil, a corresponding signal at its output.

2. Device as described in claim 1,
characterized by the fact
that an electronic circuit on synchronous switch principles is connected to the output of the comparator which electronic circuit can in each case be activated as a consequence of a change in inductance of the coupled lock and key coils (L1, L2) in such a manner that this electronic circuit checks whether a certain code is transmitted on synchronous switch principles, and that this electronic circuit reactivates the lock coil (L1) within a given time if the code received is in conformity with a given pattern.

## Revendications

1. Dispositif pour l'initialisation d'un circuit, constitué selon le principe de l'interrupteur synchronisé, avec une bobine de verrouillage (L1) et une bobine à clé (L2) selon une configuration telle, que de courts signaux de tension sont transmis à la bobine de verrouillage (L1) et que cette bobine de verrouillage (L1) est utilisée pour le transfert d'énergie vers la bobine à clé (L2) et également pour la réception de courts-circuits, qui agissent sur la bobine à clé (L2),
caractérisé
en ce que la bobine de verrouillage (L1) est reliée à un condensateur (C1) et constitue avec celui-ci un système oscillatoire et en ce que ce système oscillatoire retransmet, conformément au dimensionnement spécifique du système oscillatoire, les signaux reçus par la bobine de verrouillage (L1), à un détecteur d'amplitude maximale qui, indépendamment de la forme des signaux transmis, produit une tension, en ce qu'un deuxième condensateur (C2) à courte période de retenue en mémoire est prévu pour la mise en mémoire de cette tension, en ce que cette tension est en même temps transférable, par l'entremise d'un diviseur de tension (R2, R3), à un troisième condensateur (C3), qui possède une période de retenue en mémoire plus longue que le deuxième condensateur (C2), en ce qu'un comparateur est prévu, aux entrées duquel sont applicables les deux tensions du deuxième condensateur (C2) et du troisième condensateur (C3), et qui sur la base de la différence des tensions du deuxième et du troisième condensateur (C2, C3) en raison d'une modification à courte échéance des inductances conjuguées de la bobine de verrouillage et de la bobine à clé, produit à sa sortie un signal qui est fonction de ce fait.

2. Dispositif selon la revendication 1,
caractérisé
en ce qu'à la sortie du comparateur une électronique est reliée selon le principe de l'interrupteur synchronisé, laquelle peut dans chaque cas être commutée lors d'une modification de l'inductance des bobines couplées de verrouillage et à clé (L1, L2), de telle sorte, que cette électronique vérifie si un codage déterminé est transmis selon le principe de l'interrupteur synchronisé et qu'en outre cette électronique ne réactive la bobine de verrouillage (L1) qu'au moment prédéfini où le code reçu est conforme à un modèle prédéfini.
